# EUROPEAN PATENT APPLICATION

(11) **EP 4 703 742 A1**
(43) Date of publication of application: **04.03.2026**
(21) Application number: 23935534.0
(22) Date of filing: 22.12.2023
(51) Int. Cl.: G01R 31/12, G01R 23/00, G01R 19/12, G01R 19/10, G01R 19/165, G01R 19/175

(54) **ARC DETECTION DEVICE**

(30) Priority: 24.04.2023 KR 20230053573
(71) Applicant: LS Electric Co., Ltd., Gyeonggi-do 14119 (KR)
(72) Inventor: PARK, Youngjun, Anyang-si Gyeonggi-do 14118 (KR); SHIN, Sangtack, Anyang-si Gyeonggi-do 14118 (KR); LIM, Jongung, Anyang-si Gyeonggi-do 14118 (KR)
(74) Representative: K&L Gates LLP
(86) International application number: PCT/KR2023/021492
(87) International publication number: WO 2024/225562

(57) **Abstract**

The present invention relates to an arc detection device comprising: a high frequency signal detection unit for detecting a high frequency signal from a current flowing through a power line; a signal strength detection unit for detecting the strength of the detected high frequency signal; a voltage detection unit for detecting a change in the voltage of the power line; and a control unit for detecting zero crossing points, which are time points having a reference voltage according to phase alternation of the voltage from the change in voltage, detecting a preset number of peaks from changes in the strength of the high frequency signal detected at intervals between the detected zero crossing points, and determining whether arcs occur in the intervals by comparing signal strength values of the detected preset number of peaks to a preset reference value.

## Description

### Technical Field

The present disclosure relates to an arc detection device for detecting an arc.

### Background Art

In general, an arc means an electric flame or spark, and refers to a discharge phenomenon that occurs when a high voltage difference occurs between positive and negative terminals, and has a characteristic of high current density. The arc is known to be a main cause of electrical fires, as can be occurred by damage to wires or electrical products, insulation breakdown, connection defects, or aging of wires, and can cause fires if there is a flammable material in the vicinity.

Meanwhile, in the case of a typical leakage circuit breaker or overcurrent circuit breaker, it is provided to basically prevent a leakage or short circuit, and its interrupting function can be driven when a current above a preset magnitude is detected for more than a predetermined time period. However, in the case of an arc, it can occur even at a low current below 3 to 5 A, and there is a problem in that it is difficult to detect an arc occurring at such a low current or an arc occurring for less than a predetermined time period using a leakage circuit breaker or overcurrent circuit breaker. Accordingly, research for detecting and interrupting an arc, such as mandating the installation of an arc circuit breaker that can interrupt such an arc, is actively being conducted in various countries.

As part of the research, an arc detection device that detects noise in a current signal, and detects the occurrence of an arc using a magnitude of a high frequency component of the detected noise. However, in the case of current arc detection devices, it is determined whether an arc has occurred only based on the magnitude of a specific high frequency component detected from the noise of the current, and accordingly, there is a limitation in distinguishing between normal current noise and an arc, and as a result, there is a problem in that the precision of arc detection is not high, such as mistaking noise for an arc or misjudging an arc as noise.

### Disclosure of Invention

### Technical Problem

The present disclosure aims to solve the foregoing problems and other problems, and an aspect of the present disclosure is to provide an arc detection device that can more precisely determine whether an arc has occurred from a state of a current flowing through a circuit.

### Solution to Problem

In order to achieve the foregoing or other objectives, according to an aspect of the present disclosure, an arc detection device according to an embodiment of the present disclosure can include a high frequency signal detection unit that detects a high frequency signal from a current flowing through a power line, a signal strength detection unit that detects a strength of the detected high frequency signal, a voltage detection unit that detects a change in voltage of the power line, and a control unit that detects zero crossing points, which are time points having a reference voltage according to a phase alternation of the voltage, from the change in voltage, detects a preset number of peaks from a change in the strength of the high frequency signal detected in an intermediate interval between the detected zero crossing points, and compares signal strength values of the detected preset number of peaks with a preset reference value to determine whether an arc has occurred in the intermediate interval.

In one embodiment, the control unit can detect a number of signal strengths exceeding a preset threshold value from a change in strength of a high frequency signal detected in the intermediate interval, and determine whether the arc has occurred by detecting the preset number of peaks depending on whether the detected number is above a preset number, or determine that the arc has not occurred in the intermediate interval without detecting the preset number of peaks.

In one embodiment, the device can further include an ammeter that measures an amount of current in the circuit, wherein the control unit determines, as a result of measuring the current, whether an arc has occurred by detecting the preset number of peaks depending on whether a current change amount in the intermediate interval is above a preset ratio of a normal current amount, or determines that no arc has occurred in the intermediate interval without detecting the preset number of peaks.

In one embodiment, the control unit can determine, among the detected preset number of peaks, two different peaks adjacent to different zero crossing points in the intermediate interval as a first peak corresponding to an arc generation phase and a second peak corresponding to an arc extinction phase, respectively, and determine whether an arc has occurred in the intermediate interval based on a result of comparing a signal strength value of the first peak and a signal strength value of the second peak with preset reference values.

In one embodiment, the control unit can acquire high frequency signal information including a plurality of the intermediate intervals based on high frequency signal samples collected from the signal strength detection unit, and determine, among the first peaks and the second peaks respectively determined from the plurality of intermediate intervals included in the acquired high frequency signal information, whether the arc has occurred depending on whether there is an intermediate interval in which both the first peak and the second peak are above the reference values.

In order to achieve the foregoing or other objectives, according to an aspect of the present disclosure, an arc detection device according to an embodiment of the present disclosure can include a high frequency signal detection unit that detects a high frequency signal from a current flowing through a power line, a signal strength detection unit that detects a strength of the detected high frequency signal, a voltage detection unit that detects a change in voltage of the power line, and a control unit that detects zero crossing points, which are time points having a reference voltage according to a phase alternation of the voltage, from the change in voltage, detects strength deviations from other adjacent signals for each signal from a change in the strength of the high frequency signal detected in an intermediate interval between the detected zero crossing points, and compares signal strength values of the detected preset number of peaks with a preset reference value to determine whether an arc has occurred in the intermediate interval.

In one embodiment, the control unit can detect a first peak having a maximum deviation from a previous value and a second peak having a maximum deviation from a subsequent value, and determine whether an arc has occurred in the intermediate interval based on a result of comparing a first deviation, which is a deviation between the first peak and a value prior to the first peak, and a second deviation, which is a deviation between the second peak and a value subsequent to the second peak, with the reference values.

In one embodiment, the control unit can divide the intermediate interval into a first interval and a second interval, detect the first peak and the first deviation in the first interval, and detect the second peak and the second deviation in the second interval.

In one embodiment, the control unit can acquire high frequency signal information including a plurality of the intermediate intervals based on high frequency signal samples collected from the signal strength detection unit, and determine, among first deviations and second deviations respectively determined from the plurality of intermediate intervals included in the acquired high frequency signal information, whether the arc has occurred depending on whether there is an intermediate interval in which both a first deviation and a second deviation are above the reference values.

In one embodiment, the control unit can detect a number of signal strengths exceeding a preset threshold value from a change in strength of a high frequency signal detected in the intermediate interval, and determine whether an arc has occurred based on the deviations depending on whether the detected number is above a preset number, or determine that an arc has not occurred in the intermediate interval without detecting the deviations.

In one embodiment, the device can further include an ammeter that measures an amount of current in the circuit, wherein the control unit determines, as a result of measuring the current, whether an arc has occurred based on the deviations depending on whether a current change amount in the intermediate interval is above a preset ratio of a normal current amount, or determines that no arc has occurred in the intermediate interval without detecting the deviations.

In order to achieve the foregoing or other objectives, according to an aspect of the present disclosure, an arc detection device according to an embodiment of the present disclosure can include a high frequency signal detection unit that detects a high frequency signal from a current flowing through a power line, a signal strength detection unit that detects a strength of the detected high frequency signal, a voltage detection unit that detects a change in voltage of the power line, an ammeter that measures an amount of current in the circuit, and a control unit that detects zero crossing points, which are time points having a reference voltage according to a phase alternation of the voltage, from the voltage change, determines a first peak corresponding to an arc generation phase and a second peak corresponding to an arc extinction phase from a change in the strength of a high frequency signal detected in an intermediate interval between the detected first zero crossing point and second zero crossing point, divides the intermediate interval into a plurality of arc intervals according to the first peak and the second peak, and determines whether an arc has occurred in the intermediate interval based on a current change pattern of each of the divided arc intervals.

In one embodiment, the control unit can detect a preset number of peaks from a change in strength of a high frequency signal detected in the intermediate interval, and determine two different peaks adjacent to different zero crossing points in the intermediate interval as the first peak and the second peak among the detected preset number of peaks.

In one embodiment, the control unit can divide the intermediate interval into a first interval and a second interval, detect a first peak having a maximum deviation from a previous value in the first interval, and detect a second peak having a maximum deviation from a subsequent value in the second interval.

In one embodiment, the control unit can determine an arc interval from the first zero crossing point to the first peak as a first arc interval from a no arc phase to an arc strike phase, determine an arc interval from the first peak to the second peak as a second arc interval corresponding to an arc conduct phase, and determine an arc interval from the second peak to the second zero crossing point as a third arc interval from an arc quench phase to the no arc phase.

In one embodiment, the control unit can determine that an arc has occurred in the intermediate interval when a current reduction amount in the first and third arc intervals is above a preset ratio of a normal current amount, and a current reduction amount in the second arc interval has a pattern that is less than that in the first and third arc intervals.

In one embodiment, the ammeter can be a low frequency current transformer (LFCT) sensor.

In one embodiment, the high frequency signal detection unit can be a high frequency current transformer (HFCT) sensor.

In one embodiment, the device can further include an interrupter for interrupting an internal line to which a load is connected from the power line, wherein the control unit increases or decreases a trip count depending on whether the arc has occurred, and outputs a trip control signal for driving the interrupter to the interrupter when the increased or decreased trip count reaches a preset value.

In one embodiment, the control unit can deduct, as a result of determining whether the arc has occurred, when it is determined that the arc has not occurred, the trip count depending on whether a preset condition is satisfied.

In one embodiment, the preset condition can be satisfied when it is determined that an arc has not occurred for more than a predetermined time period.

### Advantageous Effects of Invention

The effects of an arc detection device according to the present disclosure will be described as follows.

According to at least one of embodiments of the present disclosure, the present disclosure can allow whether an arc has been detected to be determined based on the characteristics of a periodic pattern according to the occurrence and extinction of an arc according to a current flow, thereby having an effect that can more precisely determine whether an arc has occurred.

In addition, the present disclosure can allow, when the occurrence of an arc is detected, an interrupter to be driven to interrupt an internal line from a power line only when the arc is detected more than a preset number of times, thereby having an effect of preventing a malfunction in which the internal line is interrupted from the power line due to temporary noise that can be mistaken for an arc.

Moreover, the present disclosure can allow, even when an arc is detected, a number of occurrences of the arc to be deducted when measurement values for detecting the arc, such as a periodic pattern of a current signal, satisfy a preset relaxation control condition. Accordingly, the present disclosure can dynamically increase and decrease a number of arc occurrences for driving the interrupter and operate the interrupter based on the increased and decreased number of arc occurrences, thereby having an effect of ensuring reliability of the driving of the interrupter according to arc detection.

### Brief Description of Drawings

FIG. 1 is a block diagram showing a structure of an arc detection device according to an embodiment of the present disclosure.
FIG. 2 is a flowchart showing an operation process in which an arc detection device according to an embodiment of the present disclosure detects an arc and controls the driving of an interrupter based on a result of detecting the arc.
FIG. 3 is an exemplary diagram for explaining a periodic characteristic of a high frequency current signal that occurs when an arc occurs.
FIG. 4 is a flowchart showing an operation process of determining whether an arc is detected based on a zero crossing point and peaks in the vicinity of the zero crossing point in an arc detection device according to an embodiment of the present disclosure.
FIG. 5 is an exemplary diagram showing an example of detecting an arc based on peaks in the vicinity of a zero crossing point according to the operation process of FIG. 4.
FIG. 6 is a flowchart showing an operation process of determining whether an arc is detected based on deviations in each interval divided according to a zero crossing point of a current in an arc detection device according to an embodiment of the present disclosure.
FIG. 7 is an exemplary diagram showing an example of detecting an arc based on deviations in each interval divided based on a zero crossing point according to the operation process of FIG. 6.
FIG. 8 is a flowchart showing an operation process in which an arc detection device according to an embodiment of the present disclosure deducts a trip count when a preset condition is satisfied as an arc detection result.
FIG. 9 is an exemplary diagram showing an example in which an arc detection device according to an embodiment of the present disclosure further includes an LFCT that detects an amount of current.
FIG. 10 is a flowchart showing an operation process in which a control unit of the arc detection device of FIG. 9 determines whether an arc has occurred based on a change in current for each interval corresponding to each phase according to the occurrence and extinction of the arc.

### Mode for the Invention

It should be noted that the technical terms used herein are merely used to describe a specific embodiment, but are not intended to limit the present disclosure. In addition, a singular expression used herein can include a plural expression unless clearly defined otherwise in the context. A suffix "module" or "part" used for elements disclosed in the following description is merely intended for easy description of the specification, and the suffix itself is not intended to have any special meaning or function.

As used herein, terms such as "comprise" or "include" should not be construed to necessarily include all elements or steps described herein, and should be construed not to include some elements or some steps thereof, or should be construed to further include additional elements or steps.

In addition, in describing technologies disclosed herein, when it is determined that a detailed description of known technologies related thereto can unnecessarily obscure the subject matter disclosed herein, the detailed description will be omitted.

Furthermore, the accompanying drawings are provided only for a better understanding of the embodiments disclosed herein and are not intended to limit technical concepts disclosed herein, and therefore, it should be understood that the accompanying drawings include all modifications, equivalents and substitutes within the concept and technical scope of the present disclosure. In addition, not only individual embodiments described below but also a combination of the embodiments can of course fall within the concept and technical scope of the present disclosure, as modifications, equivalents or substitutes included in the concept and technical scope of the present disclosure.

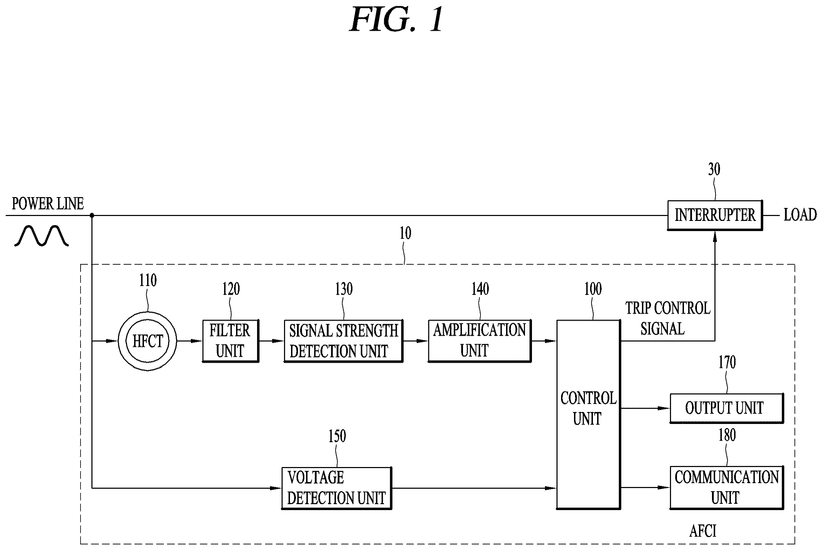

FIG. 1 is a block diagram showing a structure of an arc detection device 10 according to an embodiment of the present disclosure.

Referring to FIG. 1, the arc detection device 10 according to an embodiment of the present disclosure can be arranged between a power line of a system and an internal line to which a load is connected. In addition, a contact between the internal line and the power line can be open to connect an interrupter 30 that interrupts the internal line from the power line so as to output a trip control signal for controlling an operation of the interrupter 30 from a result of arc detection detected from the power line.

Meanwhile, as shown in FIG. 1, the arc detection device 10 according to an embodiment of the present disclosure can be formed to include a high frequency current transformer (HFCT) 110 that detects a high frequency current signal of a power line, a filter unit 120 for frequency filtering, a signal strength detection unit (power detector) 130 for detecting a signal strength of the high frequency current signal, and an amplification unit 140 and a control unit 100 that amplify a signal level of the high frequency current signal detected by the signal strength detection unit 130 into a signal at a magnitude that can be identified by the control unit 100.

In addition, the arc detection device 10 can include a voltage detection unit 150 for detecting a change in voltage of a circuit between the power line and the internal line, and can be configured to include an output unit 170 for outputting an arc detection result of the control unit 100 or a communication unit 180 for transmitting the arc detection result to a preset device.

The elements shown in FIG. 1 are not essential for implementing the arc detection device 10, and thus the arc detection device 10 described in this specification can have more or fewer elements than those listed above.

Examining more specifically, among the elements, the HFCT 110 can be a sensor for detecting a high frequency signal (hereinafter, a high frequency current signal) of a current flowing into an internal line to which a load is connected through a power line or a current flowing into the power line from the internal line. The HFCT 110 can include at least one sensor that detects a signal in a high frequency band that occurs when a partial discharge or arc occurs.

Additionally, the filter unit 120 can be a filter that filters a specific frequency using a frequency mask method. Here, the specific frequency can be a frequency corresponding to living noise, noise occurring when driving a load, or electromagnetic compatibility (EMC) noise. That is, the filter unit 120, which is a filter that filters a signal in at least one different frequency band that is designated in advance, can be a filter that removes noise whose frequency band is known in advance, such as living noise, driving noise of a load, electromagnetic compatibility noise, or the like.

Meanwhile, the signal strength detection unit 130 can detect a strength of a high frequency current signal detected through the HFCT 110. As an example, the signal strength detection unit 130 can convert the high frequency current signal detected by the HFCT 110 into a voltage signal according to its magnitude. In this case, the high frequency current signal converted into the voltage signal can be a signal in an analog form.

Meanwhile, the control unit 100 (e.g., micro controller unit (MCU)) connected to the signal strength detection unit 130 can include an analog-to-digital converter (ADC) for converting an analog high frequency current signal output from the signal strength detection unit 130 into a digital signal. Accordingly, the control unit 100 can acquire a digital signal having different values depending on a signal strength of the high frequency signal (high frequency current signal) of the current detected by the HFCT 110.

Meanwhile, the analog-to-digital converter can be provided in the signal strength detection unit 130. In this case, the signal strength detection unit 130 can output a digital signal corresponding to the high frequency current signal in an analog form converted into the voltage signal. Furthermore, the output digital signal can be input to the control unit 100. Alternatively, the analog-to-digital converter can be implemented as a separate component arranged between the signal strength detection unit 130 and the control unit 100. In this case, the analog-to-digital converter can convert an analog signal output from the signal strength detection unit 130 into a digital signal and output it to the control unit 100.

Furthermore, the amplification unit 140 can receive a digital signal input from the signal strength detection unit 130, and amplify the received digital signal into a signal at a level that can be identified by the control unit 100. Here, the amplification unit 140 can be an inverting amplifier that inverts a phase of an input signal and amplifies the inverted signal phase by having a voltage gain with a negative (-) value, or a non-inverting amplifier that maintains a phase of an input signal as it is and amplifies only its magnitude by having a voltage gain with a positive (+) value.

Meanwhile, the voltage detection unit 150 can detect a change in voltage of a power line (hereinafter collectively referred to as a power line) through which a current flows from the power line to the internal line or from the internal line to the power line.

In this case, when a current flowing through the circuit is a single-phase current, a current flowing between the power line and the internal line can be a current whose voltage phase periodically alternates according to a cycle of the single-phase current. Therefore, in the circuit, a positive (+) voltage and a negative (-) voltage periodically change, and such a voltage change can be detected through the voltage detection unit 150 and provided to the control unit 100.

The processor 100 can control each component connected thereto, and control an overall operation of the arc detection device 10. As an example, the control unit 100 can detect a time point at which a phase of voltage alternates, that is, a time point at which the phase of the voltage has a reference voltage (e.g., 0 V) at 0 degrees and 180 degrees, that is, a zero crossing point, from a voltage change of the circuit detected through the voltage detection unit 150. In this case, the voltage of the circuit can be switched from a state having a positive (+) voltage to a state having a negative (-) voltage around the zero crossing point.

Furthermore, the control unit 100 can receive a high frequency current signal amplified through the amplification unit 140. Furthermore, a change in strength of the high frequency current signal can be detected over time. In this case, the control unit 100 can detect a change in strength of a high frequency current signal corresponding to a half cycle of a single-phase current flowing from the power line to the internal line, or flowing from the internal line to the power line, based on zero crossing points detected through the voltage detection unit 150. Furthermore, based on a change in the strength of the high frequency current signal during the detected half cycle, it can be determined whether an arc has occurred during the half cycle.

To this end, the control unit 100 can determine whether the arc has occurred based on a structural characteristic of an arc signal. Here, it can be due to a periodic characteristic of occurrence and extinction of an arc between the two contacts where the arc occurs.

As an example, when an insulation between adjacent circuits is damaged or destroyed, or a crack occurs in a circuit due to aging or damage of the circuit, a voltage difference occurs between points of the insulation damage or destruction, or between two contacts (hereinafter referred to as arc contacts) of a circuit that is disconnected by the crack, and a discharge phenomenon, that is, an arc, occurs due to the voltage difference that occurs. In this manner, an arc occurs according to a voltage difference between the arc contacts, and when a voltage flowing through a circuit changes periodically, such as a single-phase current, the arc can have a periodic characteristic of occurring and extinguishing according to a change in the voltage.

Examining a periodic characteristic of occurrence and extinction of an arc, the arc can have a periodic characteristic of having an arc strike phase in which an arc begins to occur, from a state in which no arc occurs as a voltage difference between the arc contacts is small (no arc phase (no arching)), at the arc contacts as a voltage difference between the arc contacts increases, an arc conduct phase in which a current is conducted between the arc contacts through the current discharged from the arc contacts as a voltage difference between the arc contacts reaches a maximum value, and an arc quench phase in which an arc is extinguished as a voltage between the arc contacts decreases.

Meanwhile, each phase of the occurrence and extinction of the arc, that is, the no arc phase, the arc strike phase, the arc conduct phase, and the arc quench phase, can respectively have different magnitudes of an arc detected depending on a change in voltage.

For example, the arc strike phase and the arc quench phase can be phases in which an arc is most strongly occurred between the arc contacts. Additionally, the arc conduct phase, which is a phase in which a current is conducted between the arc contacts due to an arc discharge, can be a phase in which a voltage difference between the two arc contacts is at its maximum, but less arcing occurs. Additionally, the no arc phase, which is a phase in which an arc does not occur or is extinguished, can be a phase in which an arc occurs the least. Furthermore, the larger the arc, the stronger the high frequency current signal generated. Therefore, a maximum arc can occur in the arc strike phase and the arc quench phase, and an arc at a magnitude smaller than the maximum arc can occur in the arc conduct phase. On the contrary, in a no arc state, an arc can hardly occur.

Meanwhile, as an arc occurs, a high frequency current signal corresponding to a magnitude of the occurred arc can be detected by the signal strength detection unit 130. Furthermore, the control unit 100 can detect a change in the magnitude of the occurred arc according to a change in strength of the high frequency current signal detected through the signal strength detection unit 130.

Furthermore, based on a change in the magnitude of the high frequency current signal over time and a zero crossing point detected through the voltage detection unit 150, it can be determined whether the change in the magnitude of the high frequency current signal according to a change in voltage of the circuit matches a periodic characteristic of the arc, that is, an occurrence and extinction pattern of the arc. Furthermore, based on a result of the determination, it can be determined whether an arc has occurred.

Alternatively, when a pattern of change in magnitude of a high frequency current signal corresponding to occurrence and extinction of an arc is detected, the control unit 100 can check whether the pattern of change in the magnitude of a high frequency current signal corresponding to the occurrence of the arc has been detected more than a preset number of times. Furthermore, based on a result of the check, it can be determined whether the detected change pattern is due to temporary noise or the occurrence of an arc. Furthermore, when it is determined that an arc has occurred, a trip control signal for driving the interrupter 30 can be output to the interrupter 30, thereby interrupting a circuit to interrupt electricity supply. Therefore, it can be possible to prevent the risk of fire or the like due to the occurrence of an arc.

Meanwhile, when a trip control signal is output as the occurrence of an arc is detected in this manner, the control unit 100 can output an alarm signal notifying that an arc has occurred through the output unit 170. In this case, the output unit 170 can be formed to visually and audibly indicate the arc occurrence situation. Accordingly, the output unit 170 can include at least one of a speaker and a display unit.

Alternatively, the control unit 100 can include a communication unit 180 for transmitting the alarm signal to a preset server or preset device. In this case, the preset device, which is a user's terminal that is designated in advance, can include a wearable device such as a mobile phone, a smart phone, a laptop computer, a personal digital assistant (PDA), a slate PC, a tablet PC, an ultrabook, a smartwatch, smart glasses, or a head mounted display (HMD).

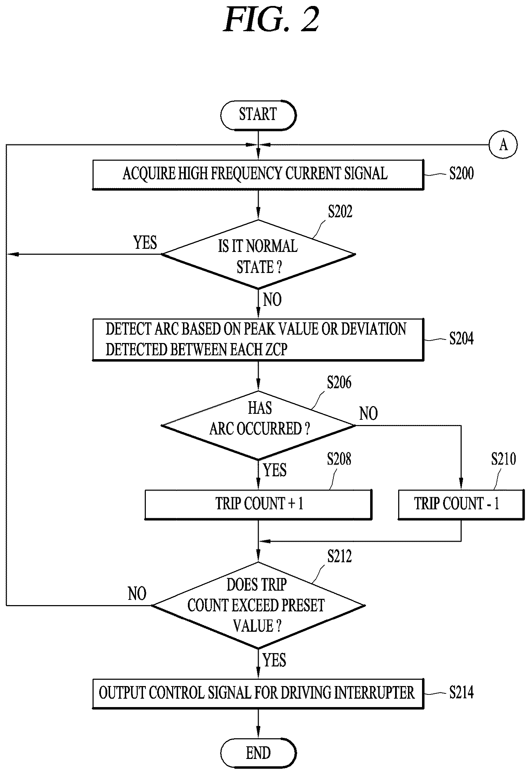

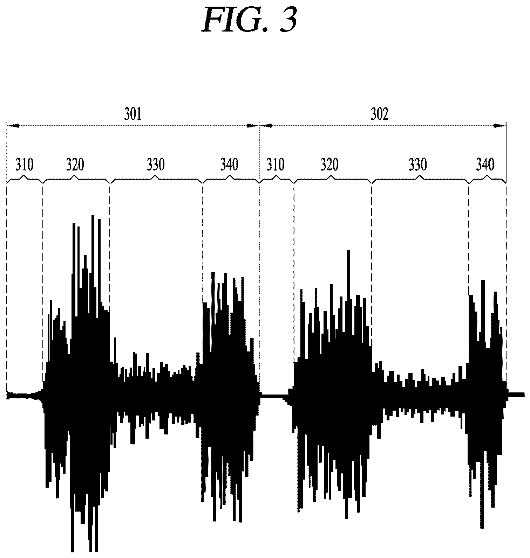

FIG. 2 is a flowchart showing an operation process in which the arc detection device 10 according to the foregoing embodiment of the present disclosure detects an arc and controls the driving of the interrupter 30 based on a result of detecting the arc. Furthermore, FIG. 3 is an exemplary diagram for explaining a periodic characteristic of a high frequency current signal that occurs when an arc occurs.

First, referring to FIG. 2, the control unit 100 of the arc detection device 10 according to an embodiment of the present disclosure can first acquire a signal detected by the signal strength detection unit 130, that is, a high frequency current signal sample, from the HFCT 110 (S200). Here, the high frequency current signal sample can be collected according to a collection cycle of the HFCT 110.

In the step S200, the control unit 100 can determine whether sufficient high frequency current signal samples have been collected to detect whether an arc has occurred. As an example, the control unit 100 can connect the collected high frequency current signal samples in time sequence, and determine whether a length of the high frequency current signal generated by connecting a plurality of high frequency current signal samples corresponds to a preset time period. Furthermore, when a high frequency current signal of a length corresponding to the preset time period is generated, it can be determined that a sufficient number of high frequency current signal samples, that is, a high frequency current signal, has been collected to detect whether an arc has occurred.

Meanwhile, as described above, it has been mentioned that the present disclosure can determine whether an arc has occurred based on a periodic pattern according to the occurrence and extinction of the arc. Therefore, the high frequency current signal capable of determining whether the arc has occurred can be a high frequency current signal having a sufficient length to allow analysis of a periodic pattern according to the occurrence and extinction of the arc.

Here, it has been described that a periodic pattern according to the occurrence and extinction of the arc consists of a no arc phase, an arc strike phase, an arc conduct phase, and an arc quench phase. In this case, the arc conduct phase has a maximum voltage difference between the two arc contacts, but as a current is conducted, most of the current flows through the two arc contacts so as to reduce a magnitude of the arc. On the contrary, the arc strike phase and the arc quench phase can be a state of occurring a large arc while a voltage difference between the two arc contacts is reduced to discharge most of the current between the two arc contacts.

FIG. 3 is an example diagram for explaining the characteristics of a high frequency current signal having a periodic pattern that occurs when an arc occurs in this manner.

First, when insulation damage or breakdown occurs in different adjacent circuits, points of insulation damage or breakdown can become contacts where an arc can occur. Alternatively, when a crack occurs in a circuit due to aging or damage, the two ends of the crack can also become contacts where an arc can occur. Hereinafter, an arc occurrence point generated due to the insulation damage, insulation breakdown, or cracks will be referred to as a contact where an arc can be formed, that is, an arc contact.

Referring to FIG. 3, due to the current characteristic of an AC current, when it approaches a time point where the voltage crosses from positive to negative, that is, a zero crossing point, a voltage difference between adjacent arc contacts can decrease. Therefore, an arc can not occur. In this manner, in a no arc phase 310 where no arc occurs between the arc contacts, a high frequency current signal resulting from the occurrence of the arc can be hardly detected because no arc occurs.

However, depending on the characteristics of an AC current, which is a single-phase current, the supplied voltage can gradually increase as it passes the zero crossing point. Then, a voltage difference between the arc contacts can gradually increase. Furthermore, when a voltage difference above a predetermined level is formed, a discharge due to the voltage difference, that is, an arc, can occur. Therefore, as the no arc phase 310 of the zero crossing point passes, an arc can occur and a strength and magnitude of the arc can increase due to an increase in the voltage difference. Therefore, it can be possible to enter a phase where a high frequency current signal with a stronger strength occurs, that is, an arc strike phase 320.

Meanwhile, when a voltage difference between the arc contacts reaches above a predetermined level as a voltage of the circuit increases, a current can flow between the two arc contacts due to an arc discharge phenomenon. In this case, a magnitude of an arc decreases as a current flows between the arc contacts. As the magnitude of the arc decreases in this manner, it can enter an arc conduct phase 330 in which the high frequency current signal decreases, as shown in FIG. 3.

In the arc conduct phase 330, when the voltage decreases again according to the characteristics of an AC current, which is a single-phase current, an arc discharge at a sufficient magnitude to conduct a current between the two arc contacts can not be carried out. Then, as a current flowing between the arc contacts is converted back into an arc, a strength and magnitude of the arc can increase again. That is, it can enter an arc quench phase 340.

Meanwhile, in the arc quench phase 340, when the voltage approaches the zero crossing point while decreasing according to the characteristics of the AC current, a voltage difference between the arc contacts can approach 0 again. Then, the arc can not occur again and the no arc phase 310 can be entered.

That is, according to the characteristics of the AC current in which a positive or negative voltage gradually increases while passing the zero crossing point and decreases again while passing the peak point to reach the zero crossing point, the arc can be occurred and extinguished through four phases: a no arc phase 310, an arc strike phase 320, an arc conduct phase 330, and an arc quench phase 340. In addition, since the arc is not a temporary noise, it can be repeated continuously. Therefore, the four-phase pattern formed during a first cycle 301 can be repeated again in a second cycle 302.

Therefore, as described in FIG. 3, when an arc occurs, a high frequency current signal detected in the HFCT 110 has a periodic pattern in which the no arc phase 310, the arc strike phase 320, the arc conduct phase 330, and the arc quench phase 340 are repeated. Additionally, since an arc occurs continuously when insulation breakdown, damage, or circuit cracking occurs, such a periodic pattern can be repeated continuously according to a voltage change cycle according to the characteristics of an AC current.

Additionally, a change in voltage of the circuit can occur periodically when a phase of the voltage alternates (e.g., when a phase of the voltage is 0 degrees or 180 degrees) depending on the characteristics of the AC current, that is, whenever the zero crossing point is passed. Meanwhile, since a time period between zero crossing points is a time period corresponding to a half cycle due to the characteristics of the AC current, the control unit 100 can determine, when a high frequency current signal sample is collected for a time period corresponding to a preset multiple of half the cycle of the AC current, that a high frequency current signal having a sufficient length to allow analysis of a periodic pattern according to the occurrence and extinction of an arc has been collected.

Meanwhile, when it is determined that a high frequency current signal at a sufficient length has been collected, the control unit 100 can first determine whether it is a suspicious state in which the occurrence of an arc is suspected or a normal state in which the occurrence of an arc is not suspected (S202). For example, the control unit 100 can detect whether there are signal strengths exceeding a preset threshold value from the acquired high frequency current signal, and determine, when a number of signal strengths exceeding the threshold value is below a preset number, a normal state in which the occurrence of an arc is not suspected. However, when a number of signal strengths exceeding the threshold value is above the preset number, it can be determined a suspicious state in which the occurrence of an arc is suspected.

Alternatively, the control unit 100 can detect a magnitude of a current flowing through the power line and internal line in the step S202, and can determine whether it is a state in which the occurrence of an arc is suspected based on the detected magnitude of the current. For example, when an arc occurs, a drop in current occurs due to the occurrence of the arc, so when an arc occurs, the current value can change by above a preset level (e.g., 5%).

Accordingly, when a current detected in a circuit between the power line and the internal line fluctuates by above 5%, the control unit 100 can determine a suspicious state in which the occurrence of an arc is suspected. However, when a fluctuation in amount of current detected in the circuit between the power line and the internal line is below 5%, it can be determined to be a normal state in which the occurrence of an arc is not suspected. In this case, the arc detection device 10 according to an embodiment of the present disclosure can further include a current sensor for detecting an amount of current from the circuit.

In addition, the control unit 100 can of course determine whether it is a normal state based on not only a fluctuation in the amount of current but also a cycle in which the amount of current changes. In this case, the control unit 100 can determine whether a fluctuation in the amount of current occurs periodically according to zero crossing points according to the AC current characteristics. That is, the control unit 100 can determine that the detection of an arc is a suspicious state when a change in the amount of current has a periodic characteristic with a minimum in the vicinity of a zero crossing point and a maximum value between zero crossing points. On the contrary, when a change in the amount of current does not have a periodic characteristic, the control unit 100 can determine that it is a normal state in which the occurrence of an arc is not suspected.

Meanwhile, the control unit 100 can determine whether it is a normal state based on a combination of two or more of the methods that determine whether it is a normal state in the step S202. As an example, the control unit 100 can determine that it is a normal state only when a fluctuation in the amount of current is below a preset level (e.g., 5%) and a change in the amount of current does not have a periodic characteristic. However, when a fluctuation in the amount of current is above 5%, or below 5% but the amount of current changes periodically (according to zero crossing points), it can be determined to be a suspicious state in which the occurrence of an arc is suspected. On the contrary, when a fluctuation in the amount of current is below 5% and the fluctuation in the amount of current does not have a periodic characteristic based on zero crossing points, it can be determined to be a normal state in which the occurrence of the arc is not suspected.

As a result of the determination in the step S202, when it is determined to be a normal state in which the occurrence of an arc is not suspected, the control unit 100 can proceed to step S200 again to continue collecting samples of high frequency current signal samples. However, as a result of the determination in the step S202, when it is not in the normal state, that is, when the occurrence of an arc is suspected, the control unit 100 can determine whether an arc has occurred based on peaks or deviations of a high frequency current signal detected between each zero crossing point (S204).

For example, in the step S204, the control unit 100 can detect a preset number of peaks in a descending order of high frequency current signal values between a first zero crossing point and a second zero crossing point. Furthermore, based on the positions of the detected peaks and the zero crossing points, one of the detected peaks can be determined as a peak corresponding to an arc strike phase, and the other can be determined as a peak of an arc quench phase.

As an example, when the preset number is two, the control unit 100 can detect two peaks in an order of higher strengths of the high frequency current signal. Here, the first zero crossing point and the second zero crossing point are zero crossing points adjacent to each other in time sequence, and the first zero crossing point can have occurred before the second zero crossing point.

Furthermore, the control unit 100 can determine, among the detected peaks, a peak close to the first zero crossing point as a peak in the arc strike phase, and a peak close to the second zero crossing point as a peak in the arc quench phase. Furthermore, the control unit 100 can determine whether an arc has occurred based on the detected peaks.

Meanwhile, in the foregoing description, the case where the preset number is two has been used as an example, but the preset number can of course be above two. For example, when the preset number is three, the control unit 100 can detect three peaks in an order of higher strengths of the high frequency current signal. Furthermore, the control unit 100 can determine, among the detected three peaks, a peak adjacent to the first zero crossing point as a peak in the arc strike phase, and a peak adjacent to the second zero crossing point as a peak in the arc quench phase. However, for the sake of convenience, the following description will assume that the preset number is two.

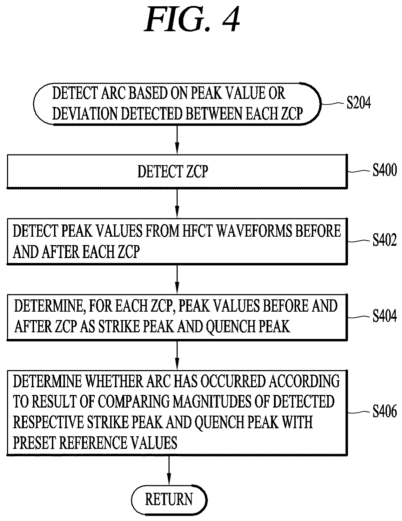

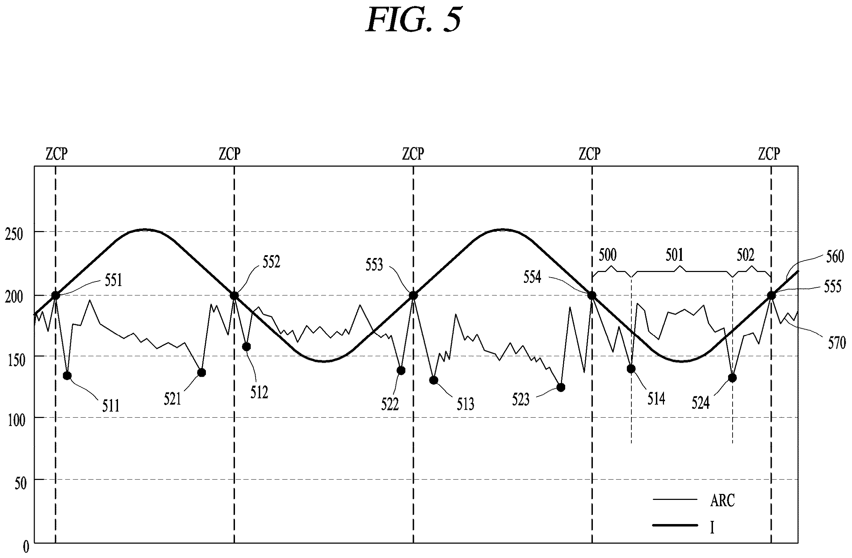

Hereinafter, with reference to FIGS. 4 and 5, an operation process of the step S204, which determines whether an arc has occurred based on zero crossing points and peaks of a high frequency current signal detected between the zero crossing points, will be examined in more detail.

Alternatively, the control unit 100 can determine whether an arc has occurred based on a deviation of high frequency current signal strengths adjacent to a zero crossing point in the step S204. For example, the control unit 100 can detect peaks having a maximum first deviation from a previous value and a maximum second deviation from a subsequent value, and determine the detected peaks as an arc strike peak and an arc quench peak, respectively. Furthermore, based on the first deviation and the second deviation, it can also be possible to determine whether an arc has occurred. This is to detect whether an arc has occurred based on the periodic characteristics of the arc, in which the arc increases rapidly (first deviation) when moving from the no arc phase to the arc strike phase, and decreases rapidly (second deviation) when moving from the arc quench phase to the no arc phase.

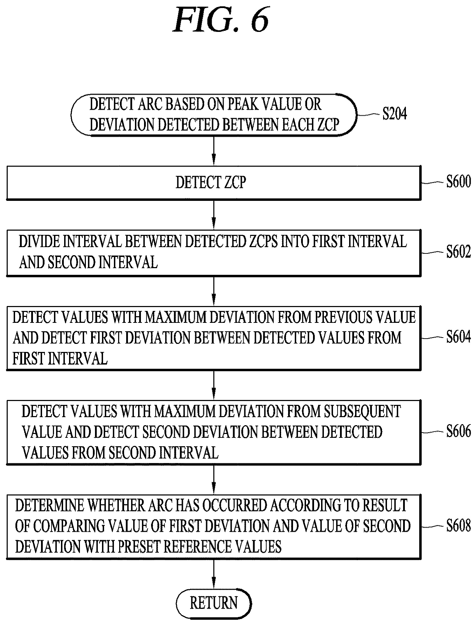

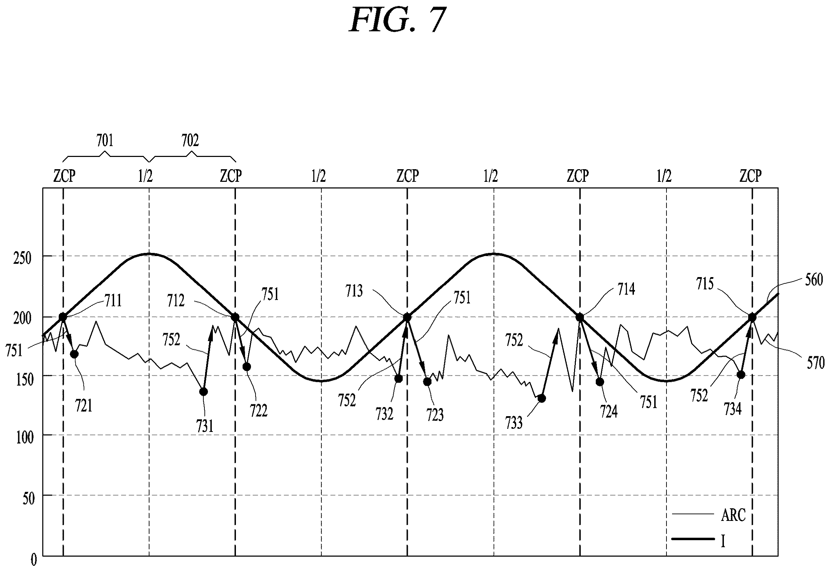

With reference to FIGS. 6 and 7 below, an operation process of the step S204, which determines whether an arc has occurred based on deviations of a high frequency current signal detected in the vicinity of a zero crossing point, will be examined in more detail.

Meanwhile, when an arc detection process of the step S204 is completed, the control unit 100 can check whether an arc has occurred (S206). Furthermore, the driving of the interrupter 30 can be controlled depending on whether the arc has occurred.

However, an arc can occur temporarily due to surge noise, switching noise, or a load transient, and can disappear naturally within a short period of time. In all those cases, when the interrupter 30 is driven to limit power supply to the load, unnecessary economic loss can occur. Accordingly, the control unit 100 of the arc detection device 10 can drive the interrupter 30 only when a number of occurrences of the arc reaches a preset number of times, thereby ensuring the reliability of the driving of the interrupter 30.

To this end, when the occurrence of an arc is detected as a result of the check in the step S206, the control unit 100 can increase the trip count for driving the interrupter 30 by 1 (S208). On the contrary, when the occurrence of an arc is not detected as a result of the check in the step S206, the trip count can be decreased by 1 (S210). In this case, the trip count can have a minimum value of 0, and when the trip count is already the minimum value of 0, the control unit 100 can maintain the current trip count as it is.

Alternatively, the control unit 100 can decrease the trip count by 1 only when the preset condition is satisfied as a result of the check in the step S206. That is, even though it is not determined that an arc has occurred, when the high frequency current signal has characteristics similar to the occurrence of an arc, the control unit 100 can maintain a current state without decreasing the trip count. Therefore, even if it is determined that no arc has occurred, the trip count can not be decreased In this case, the trip count can be increased again based on a result of determining whether an arc has occurred according to the high frequency current signal collected later, without decreasing the trip count.

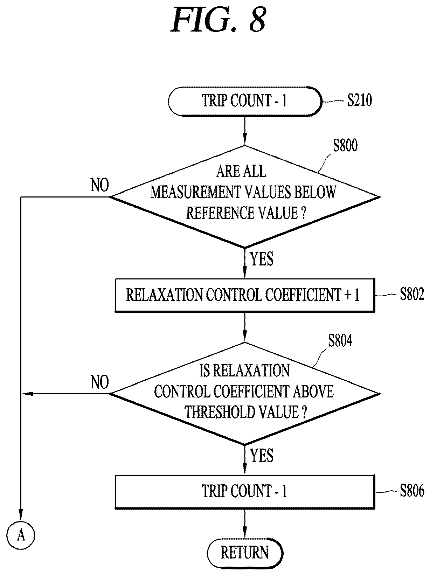

An operation process in which the control unit 100 decreases the trip count based on whether a preset condition is satisfied in this manner will be examined in detail with reference to FIG. 8.

Meanwhile, in step S208 or step S210, when an increase or decrease in the trip count is carried out, the control unit 100 can check whether the increased or decreased trip count exceeds a preset value for driving the interrupter 30 (S212). Furthermore, as a result of the check in the step S212, when the increased or decreased trip count does not exceed the preset value, the process can proceed to step S200 again to acquire a high frequency current signal for arc signal detection from the samples of the collected high frequency current signals. In this case, the operation process subsequent to the step S200 described above in FIG. 2 can be performed again.

However, as a result of the check in the step S212 when the increased or decreased trip count exceeds the preset value, the control unit 100 can output a control signal for driving the interrupter 30, that is, a trip control signal, to the interrupter 30. Then, the interrupter 30 can be driven according to the trip control signal to interrupt an internal line to which a load is connected from a power line. Then, the current supply is interrupted, so the arc can also be extinguished, and an electrical fire due to the occurrence of the arc can be prevented in advance. When a trip control signal is output in this manner, the trip count can be initialized.

Meanwhile, when the trip count exceeds the preset value as a result of the check in the step S212, the control unit 100 can first output an alarm signal notifying the occurrence of an arc through the output unit 170 prior to outputting a trip control signal. Alternatively, the alarm signal can be transmitted to a server or a preset device through the communication unit 180.

In this case, the control unit 100 can output the trip control signal to the interrupter 30 only after a preset time period has elapsed subsequent to outputting the alarm signal, or only when permission to output a trip control signal is received from the server or preset device. This notifies a user or server in advance of a trip due to the occurrence of an arc to prepare for sudden power outages, minimizing damage caused by the power outages, such as data loss or device damage.

Meanwhile, FIG. 4 is a flowchart showing an operation process of determining whether an arc is detected based on a zero crossing point of a current and peaks in the vicinity of the zero crossing point in the arc detection device 10 according to an embodiment of the present disclosure, as described above. Furthermore, FIG. 5 is an exemplary diagram showing an example of detecting an arc based on peaks in the vicinity of a zero crossing point according to the operation process of FIG. 4.

Referring to FIG. 4, the control unit 100 of the arc detection device 10 according to an embodiment of the present disclosure can first detect points corresponding to zero crossing points (ZCPs) according to a change in voltage of the circuit from a high frequency current signal acquired in the step S200 of FIG. 2 (S400). In this case, the acquired high frequency current signal, which is formed by at least one high frequency current signal sample in time sequence, can include at least two zero crossing points. Accordingly, the control unit 100 can detect time points at which the polarity of the voltage changes, that is, time points corresponding to zero crossing points, based on a change in the voltage detected during a time period corresponding to the high frequency current signal.

When zero crossing points are detected in the step S400, the control unit 100 can detect two peaks in an order of higher values, that is, signal strengths, among high frequency current signals between each zero crossing point (S402).

Furthermore, depending on whether a peak has occurred subsequent to each zero crossing point or whether a zero crossing point has occurred subsequent to the occurrence of a peak, the detected peaks can be determined as peaks of different arc phases (S404).

For example, the control unit 100 can determine a peak of a high frequency current signal that occurs first subsequent to a zero crossing point among the two peaks as a peak of an arc strike phase (hereinafter referred to as an arc strike peak). On the contrary, when a zero crossing point occurs subsequent to the occurrence of a peak, the peak can be determined as a peak of an arc quench phase (hereinafter referred to as an arc quench peak). That is, the control unit 100 can detect two peak values in an order of increasing value from between a first zero crossing point and a second zero crossing point in time sequence in the step S402, and determine a peak adjacent to the first zero crossing point between the detected peak values as an arc strike peak, and a peak adjacent to the second zero crossing point as an arc quench peak in the step S404.

FIG. 5 shows an example of determining an arc strike peak and an arc quench peak based on a zero crossing point in this manner.

Referring to FIG. 5, FIG. 5 shows a graph 570 showing a change in signal strength values of a high frequency current signal and a graph 560 showing a change in voltage detected from a circuit. Furthermore, it shows an example of a case where a high frequency current signal consisting of four intervals between five ZCPs 551, 552, 553, 554, 555 is acquired. In addition, FIG. 5 uses an inverting amplifier as the amplification unit 140, and the greater the strength of the high frequency current signal, the smaller the value can be.

Referring to FIG. 5, first, the control unit 100 can detect a preset number of peaks (e.g., 2) in an order of higher signal strengths from a high frequency current signal 560 detected in a first interval, that is, an interval between the first ZCP 551 and the second ZCP 552. In this case, due to the characteristics of the inverting amplifier, a second peak 521 having a smallest value and a first peak 511 having a next smallest value can be detected. Furthermore, the control unit 100 can determine, among the detected peaks 511, 521, the first peak 511, which is a peak that occurs first subsequent to the zero crossing point, as an arc strike peak, and the second peak 521, which is a peak where the zero crossing point occurs subsequent to the peak, as an arc quench peak.

That is, the control unit 100 can determine, among the two peak values, the first peak 511 of the high frequency current signal that occurs first in time sequence and is adjacent to the first zero crossing point 551 as an arc strike peak, and the second peak 521 of the high frequency current signal that occurs later in time sequence and is adjacent to the second zero crossing point 552 as an arc quench peak.

Furthermore, the control unit 100 can detect two peaks in an order of higher values in each interval between each zero crossing point in a similar manner. Furthermore, respective peak detected in time sequence can be determined as arc strike peaks and arc quench peaks. Therefore, in the case of the high frequency current signal 560 shown above in the FIG. 5, among the two peaks detected in an interval between each zero crossing point, the peaks 511, 512, 513, 514 that have occurred first can be determined as arc strike peaks, and the peaks 521, 522, 523, 524 that have occurred later can be determined as arc quench peaks.

Here, when the arc strike peak and the arc quench peak are determined from an interval between the zero crossing points, the control unit 100 can divide the interval between the zero crossing points into intervals corresponding to each phase of occurrence and extinction of an arc based on the determined peaks.

As an example, the control unit 100 can regard an interval 500 from the zero crossing point to the arc strike peak as an interval from a no arc phase to an arc strike phase. Additionally, an interval 501 from an arc strike peak to an arc quench peak can be regarded as an interval corresponding to an arc conduct phase. Furthermore, an interval 502 from an arc quench peak to a next zero crossing point can also be regarded as an interval from an arc quench phase to a no arc phase.

Meanwhile, when arc strike peaks and arc quench peaks are determined from intervals between each zero crossing point in the step S404, the control unit 100 can determine whether an arc has occurred based on peak values of the determined arc strike peaks and arc quench peaks (S406). In this case, the control unit 100 can compare each of the peak values of the determined arc strike peaks and arc quench peaks with a preset reference value. Furthermore, among the intermediate intervals between each zero crossing point, it can be possible to detect whether there is an interval in which both the arc strike peak and the arc quench peak are above the reference value.

Furthermore, when there is an interval in which both the arc strike peak and the arc quench peak are above the reference value, the control unit 100 can detect that an arc has occurred in the corresponding interval. Then, the control unit 100 can proceed to the step S206 of FIG. 2 to determine that an arc has been detected, and proceed to a step accordingly (e.g., step of increasing the trip count (step S208 of FIG. 2)).

On the contrary, when there is no interval among the intervals between each zero crossing point in which both the arc strike peak and the arc quench peak are above the reference value, the control unit 100 can detect that no arc has occurred. Then, the control unit 100 can proceed to the step S206 of FIG. 2 to determine that an arc is not detected, and proceed to a step accordingly (e.g., step of decreasing the trip count (step S210 of FIG. 2)).

In the foregoing description, a high frequency current signal that detects whether an arc has occurred has been described as an example in which the high frequency current signal includes intervals between a plurality zero crossing points, but the high frequency current signal can of course include only one interval between zero crossing points. In this case, the control unit 100 can detect an arc strike peak and an arc quench peak in the one interval between zero crossing points, and determine whether an arc has occurred in the one interval between zero crossing points depending on whether both the detected arc strike peak and arc quench peak exceed the reference value.

Meanwhile, unlike the description of FIGS. 4 and 5, the arc detection device 10 according to an embodiment of the present disclosure can also determine whether an arc has occurred in the corresponding interval based on a deviation between a peak value and a point corresponding to a zero crossing point. In this case, when a signal strength is increased by noise, such as when a signal strength of a high frequency current signal is temporarily increased by noise, it can be possible to prevent the occurrence of an arc from being mistakenly recognized as an increase in signal strength due to the noise, even though the high frequency current signal is not actually large.

FIGS. 6 and 7 show an example for explaining an operation process of the step S204 of FIG. 2, which determines whether an arc has occurred based on a deviation between each peak and a point corresponding to a zero crossing point.

First, FIG. 6 is a flowchart showing an operation process of determining whether an arc is detected based on deviations in each interval divided according to a zero crossing point of a current in the arc detection device 10 according to an embodiment of the present disclosure.

Referring to FIG. 6, the control unit 100 of the arc detection device 10 can first detect zero crossing points according to a change in voltage of a circuit from the high frequency current signal acquired in the step S200 of FIG. 2 (S600). In this case, when the current, the control unit 100 can detect time points having a reference voltage according to a phase alternation of the voltage, that is, time points corresponding to zero crossing points, based on a change in the voltage detected during a time period corresponding to the high frequency current signal.

Then, the control unit 100 can divide respective intervals between zero crossing points detected in the step S600 into a first interval and a second interval (S602). In this case, the first interval and the second interval can be intervals having the same time length. That is, the first and second intervals can be intervals having a time length corresponding to half of a time period between each zero crossing point. Here, the first interval can be an interval that is temporally earlier than the second interval.

In the step S602, when an interval between each zero crossing point is divided into a first interval and a second interval, the control unit 100 can detect a peak with a maximum deviation from a previous value for high frequency current signal strength values of each first interval. Furthermore, the detected peak can be determined as an arc strike peak, and a deviation between a signal strength value determined as the arc strike peak and a previous signal strength value can be detected as a first deviation (S604).

Furthermore, the control unit 100 can detect a signal strength value with a maximum deviation from a subsequent value for high frequency current signal strength values of each second interval. Furthermore, the detected signal strength value can be determined as an arc quench peak, and a deviation between a signal strength value determined as the arc quench peak and a subsequent signal strength value can be detected as a second deviation (S606).

FIG. 7 shows an example of determining a peak of an arc strike phase (hereinafter referred to as an arc strike peak) based on a deviation from a previous value, and determining a peak of an arc quench phase (hereinafter referred to as an arc quench peak) based on a deviation from a subsequent value as described above.

FIG. 7 is a graph 570 showing changes in signal strength values of a high frequency current signal and a graph 560 showing a change in voltage detected from a circuit, similar to FIG. 5, and shows an example of a case where a high frequency current signal consisting of four intervals between five ZCPs is acquired. Meanwhile, FIG. 7 uses an inverting amplifier as an amplification unit 140, and the greater the strength of the high frequency current signal, the smaller the value can be.

Referring to FIG. 7, first, the control unit 100 can divide an interval between each zero crossing point into a first interval 701 and a second interval 702. Furthermore, in each divided area, a signal strength value with a largest deviation from a previous value or a largest deviation from a subsequent value can be detected, and the detected value can be determined as an arc strike peak or arc quench peak.

For example, in an interval between a first zero crossing point 711 and a second zero crossing point 712, the control unit 100 can first detect a signal strength value with a largest deviation from a previous value from the first interval 701. In this case, when a deviation between the first zero crossing point 711 and a first peak 721 is the largest, the control unit 100 can determine the first peak 721 as an arc strike peak between the first zero crossing point 711 and the second zero crossing point 712. Furthermore, a deviation 751 between a signal strength value (first zero crossing point 711) prior to the arc strike peak 721 and the arc strike peak 721 value can be detected as a first deviation.

Furthermore, the control unit 100 can detect a signal strength value with a largest deviation from a subsequent value from the second interval 702. In this case, when a peak having a signal strength value with a largest deviation from a subsequent value is a second peak 731, the control unit 100 can determine the second peak 731 as an arc quench peak. Furthermore, a deviation 752 between the arc quench peak 731 and a signal strength value subsequent to the arc quench peak 731 can be detected as a second deviation.

Furthermore, in a similar manner thereto, the control unit 100 can detect, for each interval between zero crossing points, a signal strength value having a maximum deviation from a previous value in a first interval and a signal strength value having a maximum deviation from a subsequent value in a second interval, and determine peaks corresponding to the detected respective signal strength values as arc strike peaks and arc quench peaks, respectively.

Accordingly, in the FIG. 7, peaks 721, 722, 723, 724 with a largest deviation (first deviation) from a previous value in a first interval between each zero crossing point can be determined as arc strike peaks, and peaks 731, 732, 733, 734 with a maximum deviation (second deviation) from a subsequent value in a second interval between each zero crossing point can be determined as arc quench peaks.

Meanwhile, when arc strike peaks and arc quench peaks are determined for each interval between zero crossing points, the control unit 100 can divide the interval between the zero crossing points into intervals corresponding to each phase of occurrence and extinction of an arc based on the determined peaks.

As an example, the control unit 100 can regard an interval from the zero crossing point to the arc strike peak as an interval from a no arc phase to an arc strike phase. Additionally, an interval from an arc strike peak to an arc quench peak can be regarded as an interval corresponding to an arc conduct phase. Furthermore, an interval from an arc quench peak to the next zero crossing point can also be regarded as an interval from an arc quench phase to a no arc phase.

Meanwhile, in the step S606, when arc strike peaks and arc quench peaks and first and second deviations are determined from first and second intervals between each zero crossing point, the control unit 100 can determine whether an arc has occurred based on the determined first and second deviations. In this case, the control unit 100 can compare each of the first deviation and the second deviation with a preset reference value, and detect whether there is an interval in which both the first deviation and the second deviation are above the preset reference value among intervals between each zero crossing point of a high frequency current signal acquired in the step S200 of FIG. 2.

Furthermore, when there is an interval in which both the first deviation and the second deviation are above the reference value, the control unit 100 can detect that an arc has occurred. Then, the control unit 100 can proceed to the step S206 of FIG. 2 to determine that an arc has been detected, and proceed to a step accordingly (e.g., step of increasing the trip count (step S208 of FIG. 2)).

On the contrary, when there is no interval in which both the arc strike peak and the arc quench peak are above the reference value among the intervals between each zero point of the high frequency current signal acquired in the step S200 of FIG. 2, the control unit 100 can detect that no arc has occurred in the interval between zero crossing points. Then, the control unit 100 can proceed to the step S206 of FIG. 2 to determine that an arc is not detected, and proceed to a step accordingly (e.g., step of decreasing the trip count (step S210 of FIG. 2)).

Meanwhile, according to the foregoing description, it has been mentioned that the arc detection device 10 according to an embodiment of the present disclosure increases or decreases a trip count depending on whether an arc has been detected in an interval between zero crossing points, and outputs a trip control signal for controlling the interrupter 30 when the increased or decreased trip count exceeds a preset value, thereby ensuring the reliability of the driving of the interrupter 30.

Here, the control unit 100 can allow the trip count calculated so far to be deducted only when a preset condition is satisfied as a result of the arc detection in the step S204 of FIG. 2, thereby allowing the trip count to be gradually decreased when a stable state in which no arc occurs continues.

FIG. 8 is a flowchart showing in more detail an operation process in which the arc detection device 10 according to an embodiment of the present disclosure deducts a trip count when a preset condition is satisfied as an arc detection result as described above.

Referring to FIG. 8, when it is determined that no arc has occurred as a result of the determination in the step S206 of FIG. 2, the control unit 100 can check whether all measurement values in the step S204 of FIG. 2, which detects whether an arc has occurred, are below a preset reference value (S800).

Here, the measurement value can be a value of the arc strike peak and a value of the arc quench peak detected in an interval between zero crossing points when determining whether an arc has occurred based on peak values as described in FIGS. 4 and 5. In this case, when both the value of the arc strike peak and the value of the arc quench peak are above a first reference value, it is determined that an arc has occurred in the corresponding interval between zero crossing points, and therefore, in order to determine that an arc has not occurred as a result of the determination in the step S206 of FIG. 2, both the arc strike peak and the arc quench peak between each zero crossing point can below the reference value, or only either one can be above the first reference value. Here, the first reference value can mean a reference value applied when the measurement value is a peak value.

In addition, as described above in FIGS. 6 and 7, when determining whether an arc has occurred based on deviations, the measurement values can be a first deviation and a second deviation detected in an interval between zero crossing points. In this case, when both the first deviation and the second deviation are above a second reference value, it is determined that an arc has occurred in the corresponding interval between the zero crossing points, and therefore, in order to determine that an arc has not occurred as a result of the determination in the step S206 of FIG. 2, both the first deviation and the second deviation between each zero crossing point can be below the second reference value, or only either one can be above the reference value. Here, the second reference value can mean a reference value applied when the measurement value is a deviation value.

As a result of the check in the step S800, when neither the value of the arc strike peak nor the value of the arc quench peak is below the first reference value, or when neither the first deviation value nor the second deviation value is below the second reference value, that is, when either one of the value of the arc strike peak or the value of the arc quench peak is above the first reference value, or either one of the first deviation value and the second deviation value is above the second reference value, the control unit 100 can proceed directly to step S200 of FIG. 2 without increasing or decreasing the trip count. Therefore, the control unit 100 can determine whether an arc has occurred again while maintaining the current trip count value as it is, and increase or decrease the trip count value depending on whether an arc has occurred.

On the contrary, when both the value of the arc strike peak and the value of the arc quench peak are below the first reference value, or when both the first deviation value and the second deviation value are below the second reference value, the control unit 100 can increase a relaxation control coefficient that serves as a reference that can deduct the trip count value (S802). Furthermore, it can be checked whether the increased relaxation control coefficient is above a preset threshold value (S804). Furthermore, when the increased relaxation control coefficient is below the threshold value, the control unit 100 can proceed directly to step S200 of FIG. 2 without increasing or decreasing the trip count. Therefore, the control unit 100 can determine whether an arc has occurred again while maintaining a current trip count value.

On the contrary, as a result of the check in the step S804, when the increased relaxation control coefficient reaches the threshold value, the control unit 100 can determine that a deduction condition of the trip count is satisfied and deduct 1 from the trip count calculated so far (S806). Furthermore, the process can proceed to step S200 of FIG. 2 to perform the operation process of FIG. 2 again to acquire at least one collected high frequency current signal sample and determine whether an arc has occurred from the acquired high frequency current signal. Furthermore, depending on whether an arc has occurred, the trip count can be increased for the deducted trip count, or the trip count can be deducted again by determining whether the deduction condition is satisfied.

Alternatively, the relaxation control coefficient can increase according to a time period during which no arc has occurred. In this case, as a result of the determination by the control unit 100, the relaxation control coefficient can increase whenever a time period during which no arc has occurred reaches a predetermined time period (in this case, when the relaxation control coefficient increases, a time period during which no arc has occurred can be initialized), and when the relaxation control coefficient reaches a threshold value, the trip control count can be deducted.

Meanwhile, according to the foregoing description, it has been mentioned that the arc detection device 10 according to an embodiment of the present disclosure can not only detect a high frequency current signal from a circuit between an internal line to which a load is connected from a power line, but can also be provided with an ammeter capable of measuring an amount of current flowing through the circuit. In this case, the control unit 900 can detect a zero crossing point according to a change in voltage of the circuit, and divide an interval between each zero crossing point into intervals corresponding to each phase of occurrence and extinction of an arc based on the high frequency current signal. Furthermore, based on a change in current detected in each divided interval, whether an arc has occurred in each interval between zero crossing points can also be determined.

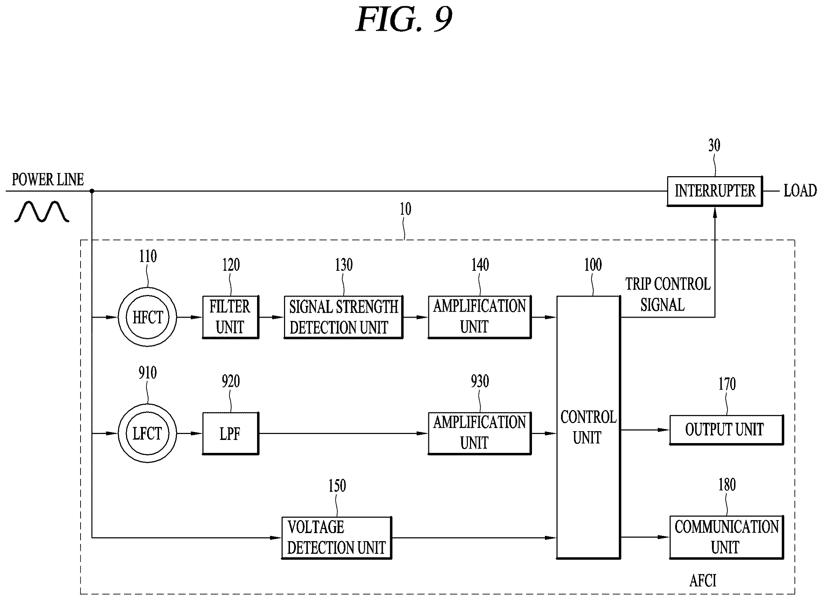

FIG. 9 is a block diagram showing a configuration of an arc detection device 20 according to another embodiment of the present disclosure, which further includes an ammeter, and detects whether an arc has occurred based on a change in current detected by the ammeter as described above. Accordingly, in order to distinguish it from the arc detection device described above, the arc detection device described above, which determines whether an arc has occurred based on a high frequency current signal detected by an HFCT 110 based on a zero crossing point according to a change in voltage as shown above in FIG. 1, will be referred to as an arc detection device 10 according to a first embodiment of the present disclosure, and an arc detection device, which determines whether an arc has occurred by considering not only the high frequency current signal detected by the HFCT 110 based on the zero crossing point but also a current change amount of an ammeter, will be referred to as an arc detection device 20 according to a second embodiment of the present disclosure.

Referring to FIG. 9, the arc detection device 20 according to the second embodiment of the present disclosure can include, similarly to the arc detection device 10 according to the first embodiment of the present disclosure, an HFCT 110, a signal strength detection unit 130 arranged between the HFCT 110 and the control unit 900 to detect a strength of the high frequency current signal, and an amplification unit 140 that amplifies a strength of the detected high frequency current signal.

In addition, the arc detection device 20 according to the second embodiment of the present disclosure can further include a low frequency current transformer (LFCT) as an ammeter for detecting an amount of current.

Referring to FIG. 9, the arc detection device 20 according to the second embodiment of the present disclosure can include an LFCT 910 for measuring a low frequency current signal of a current flowing through a circuit between a power line and an internal line to which a load is connected. In this case, since the current flowing through the circuit has a low frequency, a result of measuring a current signal by the LFCT 910 can be a result of measuring an amount of current of the current flowing through the circuit.

Meanwhile, a low pass filter (LPF) 920 can be provided between the LFCT 910 and the control unit 900 to remove noise from a result of measurement by the LFCT 910. Furthermore, an amplification unit 930 can be further provided to amplify a measurement value of the LFCT 910 to a value at a level that can be recognized by the control unit 900.

Here, a current measured through the LFCT 910 can be measured as a voltage detected through a preset shunt resistor. The shunt resistor, which is a resistor whose resistance value is known in advance, can be a separately provided resistor. Alternatively, some of the components constituting the arc detection device 10 can be used as the shunt resistor.

For example, the arc detection device 10 can use a part made of a bimetallic material part such as a switch. In this case, LFCT 900 can use a part made of a bimetallic material as a shunt resistor, and detect an amount of current flowing between the internal line from the power line based on a unique resistance value of the bimetallic material part. In this case, a separate shunt resistor can not be provided.

Meanwhile, the control unit 900 of the arc detection device 20 according to a second embodiment of the present disclosure can determine an arc strike peak and an arc quench peak from high frequency current signal strength values detected in an interval between zero crossing points, around the zero crossing points according to a change in voltage of a circuit, as described above in FIGS. 4 and 6. Furthermore, based on the determined arc strike peak and arc quench peak, and the zero crossing points, an interval between the zero crossing points can be divided into intervals (hereinafter referred to as arc intervals) according to an occurrence and extinction cycle of an arc.

As an example, the arc interval can be divided into a first arc interval to a third arc interval. Here, the first arc interval, which is an interval from a no arc interval to an arc strike phase, can mean an interval from a phase in which no arc occurs (no arc phase) as a voltage difference between the two arc contacts where the arc occurs is small to a phase in which an arc increases (arc strike phase) as the voltage difference gradually increases. In addition, the second arc interval, which is an interval from an arc strike phase to an arc quench phase, can be an interval corresponding to a phase in which the two arc contacts are conducted through an arc discharge (arc conduct phase) as the voltage difference between the two arc contacts increases above a predetermined level. Additionally, the third arc interval can be an interval from an arc quench phase in which an arc increases again while a current conducted between the two arc contacts decreases as the voltage difference that has increased to a maximum value decreases again to a phase that reaches a zero crossing point where the voltage difference becomes 0 (no arcing phase).

When the arc intervals are divided in this manner, the control unit 900 can detect a change in amount of current in each arc interval by matching a current measurement result detected through the ammeter, that is, LFCT 910, with each of the divided arc intervals.

In general, an arc is a discharge phenomenon, so when an arc occurs, the current decreases due to the discharge. In addition, the larger the arc that occurs, the greater the current decreases to a larger value. Therefore, the no arc phase is a state in which no arc occurs, that is, a state in which no current is consumed due to the occurrence of an arc, so not only a state in which the largest current flows, but also a state in which a change in current value is the smallest. On the contrary, the arc strike phase and the arc quench phase, which are phases in which the arc occurs the most, can be states in which the current consumption due to the arc is the greatest. Additionally, the arc conduct phase, which is a state in which a current is conducted between two arc contacts due to an arc, can be a state in which an arc occurs, but less arc occurs due to the conduction of the current. Therefore, the arc conduct phase is a state in which an amount of current can be reduced compared to a normal amount of current, but can be reduced less than that of the arc strike phase and arc quench phase.

Therefore, the first arc interval from a no arc phase to an arc strike phase, and the third arc interval from an arc quench phase to a no arc phase can be intervals in which a change in amount of current occurs the greatest (e.g., above 5%). Meanwhile, in the case of the second arc interval, which is an arc conduct phase, it can be an interval in which an amount of current is reduced less than in the first arc interval or the second arc interval.

That is, when an arc occurs, an amount of current changes significantly (e.g., decreases) by above a predetermined level (e.g., 5%), then increases slightly, and then changes significantly (e.g., decreases) by above a predetermined level (e.g., 5%) in a cycle of change. Therefore, the control unit 900 can determine whether an arc has occurred based on the current change pattern when such a current change pattern is periodically detected in an interval between zero crossing points. Alternatively, the control unit 900 can determine, when a change in amount of current above a preset level (e.g., 5%) is detected periodically in the interval between zero crossing points, whether an arc has occurred based on the change in amount of current.

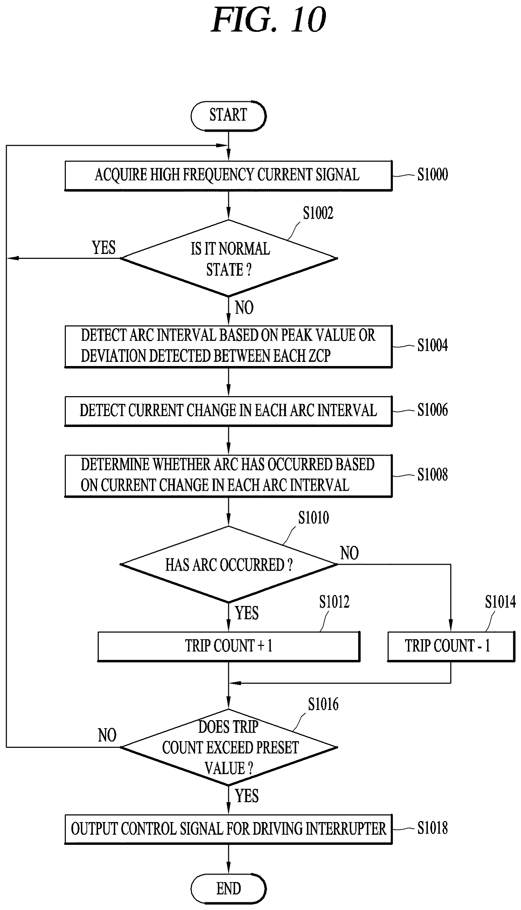

Meanwhile, FIG. 10 is a flowchart showing an operation process in which the control unit 900 of the arc detection device 20 according to a second embodiment of the present disclosure described above in FIG. 9 determines whether an arc has occurred based on a change in current for each interval corresponding to each phase of occurrence and extinction of the arc.

Referring to FIG. 10, the control unit 900 of the arc detection device 20 according to the second embodiment of the present disclosure can acquire a signal detected by the signal strength detection unit 130, that is, a high frequency current signal sample, from the HFCT 110, similar to that described above in FIG. 2. Furthermore, the control unit 900 can acquire a high frequency current signal for determining whether an arc is detected from the collected high frequency current signal sample (S1000).

Then, the control unit 900 can first determine whether the acquired high frequency current signal is in a suspicious state in which the occurrence of an arc is suspected or in a normal state in which the occurrence of an arc is not suspected (S1002). For example, the control unit 900 can detect whether there are signal strengths exceeding a preset threshold value from the acquired high frequency current signal, and determine, when a number of signal strengths exceeding the threshold value is below a preset number, a normal state in which the occurrence of an arc is not suspected. However, when a number of signal strengths exceeding the threshold value is above the preset number, it can be determined a suspicious state in which the occurrence of an arc is suspected.

Alternatively, the control unit 900 can determine that the occurrence of an arc is suspected when a current detected in a circuit between the power line and the internal line fluctuates by above a preset level (e.g., 5% of a normal current) in the step S1002. However, when a change in amount of current detected in the circuit between the power line and the internal line is below 5%, it can be determined to be a normal state in which the occurrence of an arc is not suspected.

Alternatively, the control unit 900 can of course determine whether it is a normal state based on not only a change in the amount of current but also a cycle in which the amount of current changes. In this case, the control unit 900 can determine whether a fluctuation in the amount of current occurs periodically according to zero crossing points according to the AC current characteristics. That is, the control unit 900 can determine that the detection of an arc is a suspicious state when a change in the amount of current has a periodic characteristic with a minimum in the vicinity of a zero crossing point and a maximum value between zero crossing points. On the contrary, when a change in the amount of current does not have a periodic characteristic, the control unit 900 can determine that it is a normal state in which the occurrence of an arc is not suspected.

Here, the control unit 900 can determine whether it is a normal state based on a combination of two or more of the methods that determine whether it is a normal state in the step S1002. As an example, the control unit 900 can determine that it is a normal state only when a fluctuation in the amount of current is below a preset level (e.g., 5%) and a change in the amount of current does not have a periodic characteristic. However, when a fluctuation in the amount of current is above 5%, or below 5% but the amount of current changes periodically (according to zero crossing points), it can be determined to be a suspicious state in which the occurrence of an arc is suspected. On the contrary, when a fluctuation in the amount of current is below 5% and the fluctuation in the amount of current does not have a periodic characteristic based on zero crossing points, it can be determined to be a normal state in which the occurrence of the arc is not suspected.

As a result of the determination in the step S1002, when it is determined to be a normal state in which the occurrence of an arc is not suspected, the control unit 900 can proceed to step S1000 again to reacquire a high frequency current signal from the collected high frequency current signal samples. However, as a result of the determination in the step S1002, when it is not in the normal state, that is, when the occurrence of an arc is suspected, the control unit 900 can divide the interval between zero crossing points into each arc interval based on peaks or deviations of a high frequency current signal detected between each zero crossing point (S1004).

For example, the control unit 900 can detect a preset number of peaks in an order of higher frequency current signal strengths detected between a first zero crossing point and a second zero crossing point, as described in the FIG. 4. Furthermore, among the detected peaks, a peak adjacent to the first zero crossing point can be determined as an arc strike peak, and a peak adjacent to the second zero crossing point can be determined as an arc quench peak. Furthermore, an interval between the first zero crossing point and the arc strike peak can be divided into a first arc interval, an interval between the arc strike peak and the arc quench peak can be divided into a second arc interval, and an interval between the arc quench peak and the second zero crossing point can be divided into a third arc interval.

Alternatively, the control unit 900 can divide an interval between the first zero crossing point and the second zero crossing point into a first interval and a second interval, as described above in FIG. 6. Furthermore, in the first interval, a peak with a largest deviation from a previous value can be determined as an arc strike peak, and in the second interval, a peak with a largest deviation from a subsequent value can be determined as an arc quench peak.

Furthermore, an interval between the first zero crossing point and the arc strike peak can be divided into a first arc interval, an interval between the arc strike peak and the arc quench peak can be divided into a second arc interval, and an interval between the arc quench peak and the second zero crossing point can be divided into a third arc interval.

In the step S1004, when an interval between the first zero crossing point and the second zero crossing point is divided into a first arc interval to a third arc interval, the control unit 900 can match each arc interval between the first zero crossing point and the second zero crossing point with a current measurement result of the LFCT 910.

That is, among the current measurement results of the LFCT 910, a change in amount of current measured during a time period between the first zero crossing point and the second zero crossing point can be detected to detect a change in current in intervals between the first zero crossing point and the second zero crossing point, that is, first to third arc intervals divided in the step S1004 (S1006).

Furthermore, the control unit 900 can determine whether an arc has occurred between the first zero crossing point and the second zero crossing point based on a result of detecting a change in current in each arc interval in the step S1006 (S1008).

For example, when an amount of current has a pattern in which it decreases significantly by above a predetermined level in the first arc interval, increases in the second arc interval, and then decreases significantly by above a predetermined level again in the third arc interval, the control unit 900 can determine that an arc has occurred between the first zero crossing point and the second zero crossing point. Alternatively, the control unit 900 can determine that an arc has occurred between the first zero crossing point and the second zero crossing point when a change in amount of current above a preset level (e.g., 5%) is detected between the first zero crossing point and the second zero crossing point.

Meanwhile, a high frequency current signal consisting of the plurality of high frequency current signal samples can include two or more zero crossing points. In this case, a high frequency current signal acquired in the step S1000 can include a plurality of intervals between zero crossing points.

Then, the control unit 900 can divide each interval between zero crossing points into first to third arc intervals through the step S1004. Furthermore, in the step S1006, a change in current, that is, at least one of a change pattern and a change amount, in each arc interval can be detected.

Furthermore, the control unit 900 can detect, in the step S1008, whether at least one of a change pattern detected in the step S1006 and a change in the current above a predetermined level is repeated above a predetermined number of times during an interval between the plurality of zero crossing points. Furthermore, when the change pattern in amount of current or change in current above a predetermined level is repeated, that is, depending on whether the change pattern and the change in current above a predetermined level occur periodically, it can be determined whether an arc has occurred.

Then, the control unit 900 can check whether an arc has occurred based on a result of determining whether an arc has occurred in the step S1008 (S1010). Furthermore, when an arc has occurred as a result of checking whether an arc has occurred in step S1010, the control unit 900 can control the interrupter 30 to interrupt an internal line from a power line.

Here, the control unit 900 can drive the interrupter 30 in the same manner as in the FIG. 2 to ensure the reliability of the interrupter 30 when an arc has occurred more than a preset number of times. To this end, when the occurrence of an arc is detected as a result of the check in the step S1010, the control unit 900 can increase the trip count for driving the interrupter 30 by 1 (S1012). On the contrary, when the occurrence of an arc is not detected as a result of the check in the step S1010, the trip count can be decreased by 1 (S1014). In this case, the trip count can have a minimum value of 0, and when the trip count is already the minimum value of 0, the control unit 900 can maintain the current trip count as it is.

Here, the control unit 900 can decrease the trip count by 1 only when the preset condition is satisfied as a result of the check in the step S1014. In this case, even if it is determined that an arc has not occurred, the trip count can not be decreased when a preset condition, such as a condition in which a predetermined time period elapses without the occurrence of an arc, is not satisfied. In this case, the trip count can be increased again based on a result of determining whether an arc has occurred according to the high frequency current signal collected later, without decreasing the trip count.

Meanwhile, in step S1012 or step S1014, when an increase or decrease in the trip count is carried out, the control unit 900 can check whether the increased or decreased trip count exceeds a preset value for driving the interrupter 30 (S1016). Furthermore, as a result of the check in the step S1016, when the increased or decreased trip count does not exceed the preset value, the process proceeds to step S1000 again to resume sample collection of the high frequency current signal. In this case, the operation process subsequent to the step S1000 can be performed again.

However, as a result of the check in the step S1016, when the increased or decreased trip count exceeds the preset value, the control unit 900 can output a control signal for driving the interrupter 30, that is, a trip control signal, to the interrupter 30.

Then, the interrupter 30 can be driven according to the trip control signal to interrupt an internal line to which a load is connected from a power line. Then, the current supply is interrupted, so the arc is also extinguished and an electrical fire caused by the arc can be prevented advance. Furthermore, when a trip control signal is output, the trip count can be initialized.

Meanwhile, when the trip count exceeds the preset value as a result of the check in the step S1016, the control unit 900 can first output an alarm signal notifying the occurrence of an arc through the output unit 170 prior to outputting a trip control signal. Alternatively, the alarm signal can be transmitted to a server or a preset device through the communication unit 180.

Furthermore, the trip control signal can be output to the interrupter 30 only after a preset time period has elapsed when permission to output a trip control signal is received from the server or preset device. This notifies a user or server in advance of a trip due to the occurrence of an arc to prepare for sudden power outages, minimizing damage caused by the power outages, such as data loss or device damage.

Meanwhile, in the foregoing description, the LFCT 910 has been used as an example of the ammeter, but it can of course be possible to use any other ammeter other than the LFCT 910.

Additionally, the high frequency current signal can be detected to be higher than a normal state when an inrush current occurs during an initial driving of a load connected to an internal line. In this case, in order to prevent the inrush current from being mistaken for an arc, the control unit 900 can detect whether an arc has occurred after a predetermined time period has elapsed when the initial driving of the load occurs. In this case, initial start-up time point information of the load can be provided from a preset device such as a server or a user's mobile terminal that is communicably connected to the arc detection device.

The foregoing present disclosure can be implemented as computer-readable codes on a program-recorded medium. The computer-readable medium includes all kinds of recording devices in which data readable by a computer system is stored. Examples of the computer-readable medium include a hard disk drive (HDD), a solid state disk (SSD), a silicon disk drive (SDD), a ROM, a RAM, a CD-ROM, a magnetic tape, a floppy disk, an optical data storage device and the like, and also include a device implemented in the form of a carrier wave (e.g., transmission over the Internet). Therefore, the detailed description should not be limitedly construed in all of the aspects, and should be understood to be illustrative. The scope of the present disclosure should be determined by reasonable interpretation of the appended claims, and all changes that come within the equivalent scope of the present disclosure are included in the scope of the present disclosure.

## Claims

1. An arc detection device, the device comprising:
a high frequency signal detection unit that detects a high frequency signal from a current flowing through a power line;
a signal strength detection unit that detects a strength of the detected high frequency signal;
a voltage detection unit that detects a change in voltage of the power line; and
a control unit that detects zero crossing points, which are time points having a reference voltage according to a phase alternation of the voltage, from the change in voltage, detects a preset number of peaks from a change in the strength of the high frequency signal detected in an intermediate interval between the detected zero crossing points, and compares signal strength values of the detected preset number of peaks with a preset reference value to determine whether an arc has occurred in the intermediate interval.

2. The device of claim 1, wherein the control unit detects a number of signal strengths exceeding a preset threshold value from a change in strength of a high frequency signal detected in the intermediate interval, and determines whether the arc has occurred by detecting the preset number of peaks depending on whether the detected number is above a preset number, or determines that the arc has not occurred in the intermediate interval without detecting the preset number of peaks.

3. The device of claim 1, further comprising:
an ammeter that measures an amount of current in the circuit,
wherein the control unit determines, as a result of measuring the current, whether an arc has occurred by detecting the preset number of peaks depending on whether a current change amount in the intermediate interval is above a preset ratio of a normal current amount, or determines that no arc has occurred in the intermediate interval without detecting the preset number of peaks.

4. The device of claim 1, wherein the control unit determines, among the detected preset number of peaks, two different peaks adjacent to different zero crossing points in the intermediate interval as a first peak corresponding to an arc generation phase and a second peak corresponding to an arc extinction phase, respectively, and determines whether an arc has occurred in the intermediate interval based on a result of comparing a signal strength value of the first peak and a signal strength value of the second peak with preset reference values.

5. The device of claim 4, wherein the control unit acquires high frequency signal information including a plurality of the intermediate intervals based on high frequency signal samples collected from the signal strength detection unit, and determines, among the first peaks and the second peaks respectively determined from the plurality of intermediate intervals included in the acquired high frequency signal information, whether the arc has occurred depending on whether there is an intermediate interval in which both the first peak and the second peak are above the reference values.

6. An arc detection device, the device comprising:
a high frequency signal detection unit that detects a high frequency signal from a current flowing through a power line;
a signal strength detection unit that detects a strength of the detected high frequency signal;
a voltage detection unit that detects a change in voltage of the power line; and
a control unit that detects zero crossing points, which are time points having a reference voltage according to a phase alternation of the voltage, from the change in voltage, detects strength deviations from other adjacent signals for each signal from a change in the strength of the high frequency signal detected in an intermediate interval between the detected zero crossing points, and compares signal strength values of the detected preset number of peaks with a preset reference value to determine whether an arc has occurred in the intermediate interval.

7. The device of claim 6, wherein the control unit detects a first peak having a maximum deviation from a previous value and a second peak having a maximum deviation from a subsequent value, and determines whether an arc has occurred in the intermediate interval based on a result of comparing a first deviation, which is a deviation between the first peak and a value prior to the first peak, and a second deviation, which is a deviation between the second peak and a value subsequent to the second peak, with the reference values.

8. The device of claim 7, wherein the control unit divides the intermediate interval into a first interval and a second interval, detects the first peak and the first deviation in the first interval, and detects the second peak and the second deviation in the second interval.

9. The device of claim 7, wherein the control unit acquires high frequency signal information including a plurality of the intermediate intervals based on high frequency signal samples collected from the signal strength detection unit, and determines, among first deviations and second deviations respectively determined from the plurality of intermediate intervals included in the acquired high frequency signal information, whether the arc has occurred depending on whether there is an intermediate interval in which both a first deviation and a second deviation are above the reference values.

10. The device of claim 6, wherein the control unit detects a number of signal strengths exceeding a preset threshold value from a change in strength of a high frequency signal detected in the intermediate interval, and determines whether an arc has occurred based on the deviations depending on whether the detected number is above a preset number, or determines that an arc has not occurred in the intermediate interval without detecting the deviations.

11. The device of claim 6, further comprising:
an ammeter that measures an amount of current in the circuit,
wherein the control unit determines, as a result of measuring the current, whether an arc has occurred based on the deviations depending on whether a current change amount in the intermediate interval is above a preset ratio of a normal current amount, or determines that no arc has occurred in the intermediate interval without detecting the deviations.

12. An arc detection device, the device comprising:
a high frequency signal detection unit that detects a high frequency signal from a current flowing through a power line;
a signal strength detection unit that detects a strength of the detected high frequency signal;
a voltage detection unit that detects a change in voltage of the power line;
an ammeter that measures an amount of current in the circuit; and
a control unit that detects zero crossing points, which are time points having a reference voltage according to a phase alternation of the voltage, from the voltage change, determines a first peak corresponding to an arc generation phase and a second peak corresponding to an arc extinction phase from a change in the strength of a high frequency signal detected in an intermediate interval between the detected first zero crossing point and second zero crossing point, divides the intermediate interval into a plurality of arc intervals according to the first peak and the second peak, and determines whether an arc has occurred in the intermediate interval based on a current change pattern of each of the divided arc intervals.

13. The device of claim 12, wherein the control unit detects a preset number of peaks from a change in strength of a high frequency signal detected in the intermediate interval, and determines two different peaks adjacent to different zero crossing points in the intermediate interval as the first peak and the second peak among the detected preset number of peaks.

14. The device of claim 12, wherein the control unit divides the intermediate interval into a first interval and a second interval, detects a first peak having a maximum deviation from a previous value in the first interval, and detects a second peak having a maximum deviation from a subsequent value in the second interval.

15. The device of claim 14, wherein the control unit determines an arc interval from the first zero crossing point to the first peak as a first arc interval from a no arc phase to an arc strike phase, determines an arc interval from the first peak to the second peak as a second arc interval corresponding to an arc conduct phase, and determines an arc interval from the second peak to the second zero crossing point as a third arc interval from an arc quench phase to the no arc phase.

16. The device of claim 15, wherein the control unit determines that an arc has occurred in the intermediate interval when a current reduction amount in the first and third arc intervals is above a preset ratio of a normal current amount, and a current reduction amount in the second arc interval has a pattern that is less than that in the first and third arc intervals.

17. The device of claim 12, wherein the ammeter is a low frequency current transformer (LFCT) sensor.

18. The device of any one of claims 1 to 6, and 12, wherein the high frequency signal detection unit is a high frequency current transformer (HFCT) sensor.

19. The device of any one of claims 1 to 6, and 12, further comprising:
an interrupter for interrupting an internal line to which a load is connected from the power line,
wherein the control unit increases or decreases a trip count depending on whether the arc has occurred, and outputs a trip control signal for driving the interrupter to the interrupter when the increased or decreased trip count reaches a preset value.

20. The device of claim 19, wherein the control unit deducts, as a result of determining whether the arc has occurred, when it is determined that the arc has not occurred, the trip count depending on whether a preset condition is satisfied.

21. The device of claim 20, wherein the preset condition is satisfied when it is determined that an arc has not occurred for more than a predetermined time period.
